(19) Europäisches Patentamt
European Patent Office
Office européen des brevets

(11) **EP 2 265 964 B1**

(12) **EUROPÄISCHE PATENTSCHRIFT**

(45) Veröffentlichungstag und Bekanntmachung des Hinweises auf die Patenterteilung:
**29.08.2012 Patentblatt 2012/35**

(21) Anmeldenummer: **09731039.5**

(22) Anmeldetag: **12.02.2009**

(51) Int Cl.:
***H02M 7/5387*** (2007.01)

(86) Internationale Anmeldenummer:
**PCT/EP2009/051610**

(87) Internationale Veröffentlichungsnummer:
**WO 2009/124798 (15.10.2009 Gazette 2009/42)**

(54) **VERFAHREN UND VORRICHTUNG ZUR STROMMESSUNG IN PHASENLEITUNGEN**

METHOD AND DEVICE FOR CURRENT MEASUREMENT IN PHASE LINES

PROCÉDÉ ET DISPOSITIF DE MESURE DU COURANT DANS DES LIGNES DE PHASE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **07.04.2008 DE 102008001025**

(43) Veröffentlichungstag der Anmeldung:
**29.12.2010 Patentblatt 2010/52**

(73) Patentinhaber: **Robert Bosch GmbH 70442 Stuttgart (DE)**

(72) Erfinder:
• **Finke, Sven**
  **70839 Gerlingen (DE)**
• **Kuehn, Timo**
  **76307 Karlsbad (DE)**

(56) Entgegenhaltungen:
**EP-A1- 1 347 567     DE-A1-102005 062 759**
**US-A- 5 309 349     US-A1- 2003 006 749**

EP 2 265 964 B1

**Beschreibung**

Technisches Gebiet

Die Erfindung betrifft ein Verfahren zur Strommessung in einem insbesondere mehrphasigen Stromnetz.

Stand der Technik

Ein mehrphasiges Stromnetz wird beispielsweise zur Bestromung eines Elektromotors eingesetzt. Ein in einer Phase des mehrphasigen Stromnetzes flie-βender Strom kann mittels eines niederohmigen Widerstands (Shunt) gemessen werden. Bei der so genannten 1-Shunt-Strommessung können die Ströme in den einzelnen Phasen über einen einzigen Shunt ermittelt werden. Dabei können jedoch offsetbedingte Messungenauigkeiten auftreten.

Die Druckschrift US 5,309,349 A offenbart ein Verfahren zur Strommessung in einem dreiphasigen Stromnetz mithilfe eines einzigen Stromsensors, um die Dreiphasen-Wechselstrome zu detektieren und zu errechnen. Die Strommess - einrichtung ist zwischen dem Schalter und einem Spannungspotential angeordnet, wobei Stromwerte der Phasenströme für die erste und die zweite Phase bei bestimmten Schaltzustanden der Schalter ermittelt werden. Der Stromwert des Phasenstroms für die dritte Phase wird aus dem zuvor detektierten Stromwert der ersten und zweiten Phase berechnet.

Der Erfindung liegt die Aufgabe zugrunde, eine verbesserte Strommessung zu ermöglichen.

Offenbarung der Erfindung

Die vorliegende Erfindung ermöglicht eine automatische Messfehlerkompensation, die beispielsweise bei einer 1-Shunt-Strommessung eingesetzt werden kann. Der erfindungsgemäße Ansatz basiert dabei auf einer Definition von Abtastzeitpunkten zur Ermittlung auftretender Offsetfehler. Bei der 1-Shunt-Strommessung können zwei offsetbedingte Messfehler entstehen. Dabei han-delt es sich um einen Operationsverstärker-Offset und einen Ripple-Offset, der seine Ursache in der Phasenspannungsausgabe mittels asymmetrischer Pulsweitenmodulation (PWM) mit Phasenverschiebung haben kann. Gemäß dem erfindungsgemäßen Ansatz ist es nicht mehr erforderlich, dass diese OffsetFehler durch einen Bandende-Abgleich ermittelt und beispielsweise in einem EEPROM eines Steuergerätes hinterlegt werden. Durch eine Einsparung des Bandende-Abgleichs ergibt sich eine Kosteneinsparung. Die beschriebenen Offset-Anteile sind nicht in sämtlichen Arbeitspunkten konstant. Außerdem unterliegen sie gewissen Afterungs-Effekten. Diese Effekte lassen sich erfindungsgemäß berücksichtigen, so dass die Qualität der Strommessung verbessert werden kann. Vorteilhafterweise lässt sich der erfindungsgemäße Ansatz mit bekannten Messverfahren kombinieren. Alternativ kann der erfindungsgemäße Ansatz auch für sich alleine verwendet werden.

Ein Verfahren zur Strommessung in einem mehrphasigen Stromnetz ist bekannt, das die folgenden Schritte aufwieist:

- Herstellen einer leitenden Verbindung zwischen einer Mehrzahl der Phasen des mehrphasigen Stromnetzes, so dass die Mehrzahl der Phasen miteinander kurzgeschlossen sind; und
- Erfassen eines zwischen der leitenden Verbindung und einem ersten Spannungspotential fließenden Stromwertes zu einem Erfassungszeitpunkt.

Das Erfassen des Stromwertes kann mittels einer Messeinrichtung erfolgen, die zwischen der leitenden Verbindung und dem ersten Spannungspotential angeordnet ist. Dies ermöglicht beispielsweise den Einsatz eines Shunts.

Die Mehrzahl der Phasen kann über mindestens einen ersten Schalter mit der Messeinrichtung verbunden sein und der mindestens eine erste Schalter kann zu dem Erfassungszeitpunkt geschlossen sein. Somit eignet sich das Verfahren zum Einsatz bei einer 1-Shunt-Strommessung.

Ferner kann jede der Mehrzahl der Phasen über jeweils einen ersten Schalter mit der Messeinrichtung verbunden sein und alle ersten Schalter zu dem Erfassungszeitpunkt geschlossen sein. Eine solche Anordnung kann im Zusammenhang mit einer Brückenschaltung eingesetzt werden, mit der ein mehrphasiger Verbraucher angesteuert werden kann.

Zwischen einem Schließen eines letzten ersten Schalters und dem Erfassungszeitpunkt kann eine vorbestimmte Mindestzeitdauer liegen. Dadurch kann sichergestellt werden, dass die verwendete Messeinrichtung eingeschwungen ist.

Die Mehrzahl der Phasen kann über mindestens einen zweiten Schatter mit einem zweiten Spannungspotential verbunden sein. Dies ermöglicht eine Einbindung eines mehrphasigen Verbrauchers in einen Gleichspannungsstromkreis.

Ferner kann die leitende Verbindung zwischen allen Phasen des mehrphasigen Stromnetzes hergestellt werden.

Gemäß einer Ausgestaltung kann der Stromwert eine Kompensation einer Nullpunktverschiebung der Messeinrichtung ermöglichen.

Gemäß einer weiteren Ausgestaltung schafft die vorliegende Erfindung ein Verfahren zur Strommessung in einem mehrphasigen Stromnetz, das die folgenden Schritte aufweist:

- Erfassen eines zwischen einer ersten Phase des mehrphasigen Stromnetzes und einem ersten Spannungspotential fließenden ersten Stromswertes zu einem ersten Erfassungszeitpunkt;
- Erfassen eines zwischen der ersten Phase und dem ersten Spannungspotential fließenden zweiten Stromwertes zu einem zweiten Erfassungszeitpunkt, wobei der erste und der zweite Erfassungszeitpunkt so gewählt sind, dass der erste und der zweite Stromwert unterschiedliche Vorzeichen aufweisen; und
- Ermitteln eines Stromwertes aus dem ersten und dem zweiten Stromwert.

Das Erfassen des ersten und des zweiten Stromwertes kann mittels einer Messeinrichtung erfolgen, die zwischen dem ersten Spannungspotential und einer Mehrzahl erster Schalter angeordnet ist, wobei jeweils eine Phase des mehrphasigen Stromnetzes über jeweils einen der Mehrzahl erster Schalter mit der Messeinrichtung verbunden ist. Somit eignet sich das Verfahren zum Einsatz bei einer 1-Shunt-Strommessung.

Zu dem ersten Erfassungszeitpunkt kann nur ein, der ersten Phase zugeordneter erster Schalter geschlossen sein und zu dem zweiten Erfassungszeitpunkt kann nur der, der ersten Phase zugeordnete erste Schalter geöffnet sein. Dieses Schaltmuster ermöglicht die Ermittlung eines Wertes für eine Offsetfehlerkompensation der Strommessung.

Der erste Erfassungszeitpunkt kann eine erste vorbestimmte Zeitdauer von einem ersten Schaltvorgang des, der ersten Phase zugeordneten ersten Schalters beabstandet und der zweite Erfassungszeitpunkt kann eine zweite vorbestimmte Zeitdauer von einem zweiten Schattvorgang des, der ersten Phase zugeordneten ersten Schalters beabstandet sein. Somit kann erreicht werden, dass die zum ersten und zweiten Erfassungszeitpunkt erfassten Ströme zueinander symmetrisch sind.

Erfindungsgemäß entspricht die erste vorbestimmte Zeitdauer der zweiten vorbestimmten Zeitdauer. Somit ist ein zeitlicher Abstand zwischen den Erfassungszeitpunkten und den jeweils zugeordneten Schaltvorgängen identisch.

Ferner kann der Stromwert als Mittelwert aus dem ersten und dem zweiten Stromwert ermittelt werden.

Gemäß dieser Ausgestaltung kann ein dem zweiten Stromwert entsprechender Wert von einem Speicher bereitgestellt werden, wenn das Erfassen des zweiten Stromwertes zu dem zweiten Erfassungszeitpunk nicht möglich ist.

Ferner kann jede Phase des mehrphasigen Stromnetzes über jeweils einen zweiten Schalter mit einem zweiten Spannungspotential verbindbar sein, wobei zu dem ersten Erfassungszeitpunkt nur ein zweiter Schalter der ersten Phase geöffnet und zu dem zweiten Erfassungszeitpunkt nur der zweite Schalter der ersten Phase geschlossen sein kann. Somit kann das Verfahren bei einer Brückenschaltung zur Ansteuerung eines mehrphasigen Verbrauchers eingesetzt werden.

Eine mögliche Vorrichtung zur Strommessung in einem mehrphasigen Stromnetz umfasst:

eine Mehrzahl von ersten Schaltern zum Herstellen einer leitenden Verbindung zwischen einer Mehrzahl der Phasen des mehrphasigen Stromnetzes, so dass die Mehrzahl der Phasen miteinander kurzgeschlossen sind;

eine Steuereinrichtung zum Ansteuern der Mehrzahl von ersten Schaltern; und eine Messeinrichtung zum Erfassen eines zwischen der leitenden Verbindung und einem ersten Spannungspotential fließenden Stromwertes zu einem Erfassungszeitpunkt.

Die Messeinrichtung kann insbesondere als Messwiderstand ausgeformt sein und zwischen der leitenden Verbindung und dem ersten Spannungspotential angeordnet sein.

Die Mehrzahl der Phasen können über mindestens einen der Mehrzahl von ersten Schaltern mit der Messeinrichtung verbunden sein, und die Steuereinrichtung kann ausgebildet sein, um die Mehrzahl von ersten Schaltern so anzusteuern, dass der mindestens eine erste Schalter zu dem Erfassungszeitpunkt geschlossen ist.

Jede der Mehrzahl der Phasen kann über jeweils einen der Mehrzahl von ersten Schaltern mit der Messeinrichtung verbunden sein, und die Steuereinrichtung kann ausgebildet sein, um die Mehrzahl von ersten Schaltern so anzusteuern, dass alle ersten Schalter zu dem Erfassungszeitpunkt geschlossen sind.

Die Steuereinrichtung kann ausgebildet sein, um die Mehrzahl von ersten Schaltern so anzusteuern, dass zwischen einem Schließen eines letzten ersten Schalters und dem Erfassungszeitpunkt eine vorbestimmte Mindestzeitdauer liegt.

Die Vorrichtung kann mindestens einen zweiten Schalter aufweisen, wobei die Mehrzahl der Phasen über den mindestens einen zweiten Schalter mit einem zweiten Spannungspotential verbunden sind.

Gemäß einer Ausgestaltung schafft die vorliegende Erfindung eine Vorrichtung zur Strommessung in einem mehrphasigen Stromnetz, umfassend: eine Messeinrichtung, die ausgebildet ist, um einen zwischen einer ersten Phase des mehrphasigen Stromnetzes und einem ersten Spannungspotential fließenden ersten Stromswert zu einem ersten Erfassungszeitpunkt und einen zwischen der ersten Phase und dem ersten Spannungspotential fließenden zweiten Stromwert zu einem zweiten Erfassungszeitpunkt zu erfassen, wobei der erste und der zweite Erfassungszeitpunkt so gewählt sind, dass der erste und der zweite Stromwert unterschiedliche Vorzeichen aufweisen; und eine Einrichtung zum Ermitteln eines Stromwertes aus dem ersten und dem zweiten Stromwert.

Die Vorrichtung kann eine Mehrzahl erster Schalter aufweisen, wobei die Messeinrichtung zwischen dem ersten Spannungspotential und der Mehrzahl erster Schalter angeordnet und jeweils eine Phase des mehrphasigen Stromnetzes über jeweils einen der Mehrzahl erster Schalter mit der Messeinrichtung verbunden ist.

Dabei kann nur ein der ersten Phase zugeordneter erster Schalter zu dem ersten Erfassungszeitpunkt geschlossen und zu dem zweiten Erfassungszeitpunkt geöffnet ist.

Der erste Erfassungszeitpunkt kann eine erste vorbestimmte Zeitdauer von einem ersten Schaltvorgang des, der ersten Phase zugeordneten ersten Schalters beabstandet sein und der zweite Erfassungszeitpunkt kann eine zweite vorbestimmte Zeitdauer von einem zweiten Schaltvorgang des, der ersten Phase zugeordneten ersten Schalters beabstandet sein. Die erste vorbestimmte Zeitdauer kann der zweiten vorbestimmten Zeitdauer entsprechen.

Die Vorrichtung kann einen Speicher aufweisen, der ausgebildet ist, um einen dem zweiten Stromwert entsprechenden Wert bereitzustellen, wenn das Erfassen des zweiten Stromwertes zu dem zweiten Erfassungszeitpunk nicht möglich ist.

Die Vorrichtung kann eine Mehrzahl zweiter Schalter aufweisen, die so angeordnet sind, dass jede Phase des mehrphasigen Stromnetzes über jeweils einen der Mehrzahl der zweiten Schalter mit einem zweiten Spannungspotential verbindbar ist, wobei nur ein der ersten Phase zugeordneter zweiter Schalter zu dem ersten Erfassungszeitpunkt geöffnet und zu dem zweiten Erfassungszeitpunkt geschlossen ist.

Die Erfindung ist anhand von Ausführungsbeispielen in den Zeichnungen schematisch dargestellt und wird im Folgenden unter Bezugnahme auf die Zeichnungen ausführlich beschrieben.

Kurze Beschreibung der Zeichnungen

Die Zeichnungen veranschaulichen die Erfindung anhand von Ausführungsbeispielen. Es zeigen:

Figur 1 ein mehrphasiges Stromnetz;
Figuren 2 bis 4 verschiedene Schaltmuster;
Figur 5 ein mehrphasiges Stromnetz; und
Figur 6 ein weiteres Schaltmuster.

Ausführungsformen der Erfindung

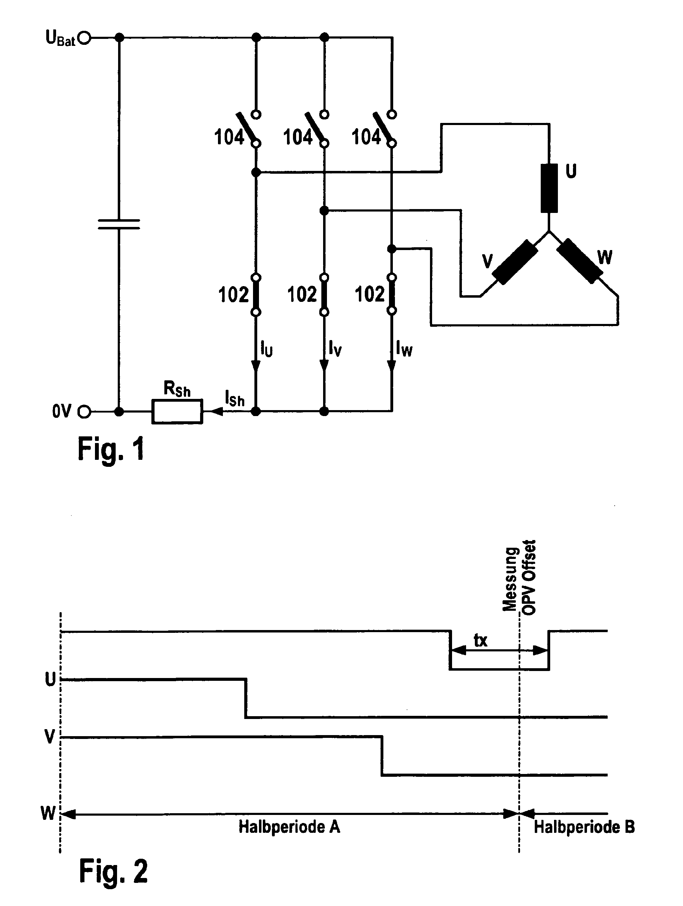

Die Figur 1 zeigt ein mehrphasiges Stromnetz mit einer Brückenschaltung gemäß einem Ausführungsbeispiel der vorliegenden Erfindung. Die Brückenschaltung weist drei Brückenzweige auf. Jeder Brückenzweig weist einen ersten Schalter 102 und einen zweiten Schalter 104 auf. Die Brückenschaltung ist ausgebildet, um einen dreiphasigen Verbraucher anzusteuern. Dazu sind ein erster Brückenzweig mit einer ersten Phase U, ein zweiter Brückenzweig mit einer zweiten Phase V und ein dritter Brückenzweig mit einer dritten Phase W des Verbrauchers verbunden. Der Verbraucher kann als dreiphasiger Asynchronmotor ausgebildet sein. Die ersten Schalter 102 und die zweiten Schalter 104 können von einer nicht dargestellten Steuereinheit angesteuert werden.

Die Brückenschaltung ist mit einem Gleichstromkreis verbunden, der als Stromzwischenkreis ausgebildet sein kann. Dazu ist ein erster Anschluss der Brückenschaltung über einen Widerstand $R_{Sh}$, der als Shunt ausgeformt sein kann, mit einem ersten Spannungspotential 0V verbunden. Ein zweiter Anschluss der Brückenschaltung ist mit einem zweiten Spannungspotential $U_{Bat}$ verbunden. Zwischen dem ersten und dem zweiten Anschluss der Brückenschaltung ist ein Kondensator geschaltet.

Über die ersten Schalter 102 fließende Phasenströme $I_u$, $I_v$, $I_w$ vereinigen sich in einem Knotenpunkt zu einem Strom $I_{Sh}$, der durch den Widerstand $R_{Sh}$ fließt. Der Widerstand $R_{Sh}$ kann Teil einer Messeinrichtung sein, die ausgebildet ist, um den Strom $I_{Sh}$ zu erfassen. Die Messeinrichtung kann eine Messverstärkerschaltung und einen Analog-Digital-Wandler aufweisen, der das analoge Signal des Widerstands $R_{Sh}$ in ein digitales Signal umwandelt. Die Messverstärkerschaltung kann im Betrieb eine Einschwingzeit aufweisen. Der Analog-Digital-Wandler kann eine Abtastzeit und die Schalter 102, 104, die als Feldeffekttransistoren (FET) ausgebildet sein können, können eine Totzeit aufweisen. Diese Zeiten sind bei der Messung über den Widerstand $R_{Sh}$ zu berücksichtigen.

Beispielsweise können mit dem Widerstand $R_{Sh}$ die Phasenströme $I_u$, $I_v$, $I_w$ in sequenzieller Folge ermittelt werden. Dazu können zwei der insgesamt drei Phasenströme $I_u$, $I_v$, $I_w$ gemessen und der dritte Phasenstrom mittels der Kirchhoffschen Gesetze berechnet werden. Zur Messung der Phasenströme $I_u$, $I_v$, $I_w$ kann ein bestimmtes Schaltmuster, also eine bestimmte Ansteuerung der Schalter 102, 104 erforderlich sein, damit der Strom durch den Widerstand $R_{Sh}$

dem zu messenden Phasenstrom $I_u$, $I_v$. $I_w$ entspricht.

Zur Ansteuerung der Schalter 102, 104 kann ein Taktmuster gewählt werden, bei dem Schaltzeiten der Schalter 102, 104 zeitlich verschoben sind, sodass die Messung von mindestens zwei der drei Phasenströme $I_u$, $I_v$, $I_w$ innerhalb einer Pulsweitenmodulations-Periode möglich ist. Beispielsweise kann zum Zeitpunkt einer ersten Messung der Strom durch den Widerstand $R_{Sh}$ dem Strom in der Phase U und zum Zeitpunkt der zweiten Messung dem inversen Strom in der Phase W, dies entspricht der Addition der Phasenströme U und V entsprechen. Die Messungen können in einer von zwei Teilperioden A, B der Pulsweitenmodulations-Periode durchgeführt werden. Die Summe der Teilperioden A, B ergibt die Pulsweitenmodulations-Periode.

Gemäß einer Ausführung kann ein Offsetfehler der Messverstärkerschaltung mit dem Widerstand $R_{SH}$ kompensiert werden.

Da der Messbereich der Strommessung einen positiven und einen negativen Bereich aufweisen soll, ist es erforderlich, den Eingang der Verstärkerschaltung auf ein mittleres Potential vorzuspannen. Hierzu kann mit Hilfe eines Wider standsspannungsteilers der Eingang des Operationsverstärkers (OPV) der Messverstärkerschaltung auf Mittenspannung gelegt werden. Dieser Widerstandsspannungsteiler kann bei der Produktion beispielsweise eines zugeordneten Steuergerätes (ECU) **mit** Hilfe von Lasern abgeglichen werden und ist somit hoch genau. Eine Veränderung der Widerstände über die Temperatur kann jedoch nicht verhindert werden. Dies kann zu einer Verschiebung der Mittenspannung und damit des Nullpunktes der Strommessung führten. Hinzu kann noch eine Temperaturdrift des Operationsverstärkers selber kommen. Beide Effekte können somit zu einem temperaturabhängigen Offsetfehler auf der Strommessung führen.

Der beschriebene Ansatz ermöglicht eine automatische Kompensation des Operationsverstärker-Offset.

Wie in Figur 1 gezeigt, befindet sich der Shunt $R_{Sh}$ zur Strommessung in der Verbindung zum Zwischenkreis. Dies entspricht dem Aufbau einer 1-Shunt-Strommessung. Somit ergibt sich hier gegenüber einem Aufbau bei einer 3-Shunt-Strommessung der Vorteil, dass lediglich der Zwischenkreisstrom zu Null werden muss. Somit besteht eine Unabhängigkeit von den Phasenströmen $I_u$, $I_v$, $I_w$ und es ist nicht zwangsläufig erforderlich, das Abgabemoment zu Null gehen zu lassen. Gemäß dem oben beschriebenen Ansatz wird ein Schaftmuster gesucht, bei dem eine Ermittlung des Offsetwertes der Operationsverstärker-Schaltung möglich ist. Ein solches Schaltmuster ist gegeben, wenn alle Low-Side-Schalter 102 bzw. alle High-Side-Schalter 104 an sind.

Ein solches Schaltmuster zur Ermittlung des Operationsverstärker-Offsets ist in Figur 1 gezeigt. Gemäß dieser Ausführung ist der dreiphasige Verbraucher als Motor und die Schalter 102, 104 als FETs ausgebildet. Bei dem in Figur 1 gezeigten Schaltmuster sind alle drei Motorphasen U, V, W über die Low-Side FETs kurz geschlossen, so dass der Zwischenkreisstrom und folglich auch der Strom durch den Shunt $R_{Sh}$ zu Null wird. Zu diesem Zeitpunkt wird die Spannung über den Shunt $R_{Sh}$ abgetastet. Dadurch lässt sich ein Wert der Nullpunktverschiebung der Strommessung erhalten, mit dessen Hilfe die Kompensation des Offsetfehlers durch Subtraktion erfolgen kann. Hierbei ist zu beachten, dass das Schaltmuster vor der Abtastung ausreichend lange ausgegeben wird, damit am Eingang des Analog-Digital-Wandler der Messschaltung ein eingeschwungener Wert anliegt. Diese Forderung bedeutet für den Operationsverstärker-Offset, dass am Ende der Halbperiode A ein Nullspannungsvektor solange ausgegeben werden wird, bis der Strommessverstärker eingeschwungen ist.

Somit ergibt sich eine obere Pulsweitenmodulation-Grenze für die einzelnen Phasen U, V, W, unterhalb der die Operationsverstärker-Offsetmessung möglich ist. Dieser Grenzwert ist von der Phasenverschiebung der entsprechenden Phase abhängig. Grundsätzlich gilt:

$$\text{PWM}_{max} = (T_{PWM} - T_{phaseshift} - t_x) / T_{PWM} \qquad (1)$$

$\text{PWM}_{max}$ stellt die obere Pulsweitenmodulation-Grenze der jeweiligen Phase U, V, W dar, $T_{PWM}$ steht für die Periodendauer der Pulsweitenmodulation und die Zeiten $T_{Setiinkopv}$, $T_{phaseshift}$ und $T_{sampte}$ spiegeln die Einschwingzeit des Operationsverstärkers, die Phasenverschiebung und die Abtastzeit wider. Die Zeit $t_x$ ergibt sich aus

$$t_x = \text{Totzeit} + \text{Einschwingzeit OPV} + \text{Abtastzeit.}$$

Figur 2 zeigt eine Darstellung einer maximalen Pulsweitenmodulation, bei der eine Messung des Operationsverstärker-Offsets möglich ist. Gezeigt sind die Tastmuster auf den Phasen U, V, W in der Halbperiode A und der Halbperiode B. Die Übergänge in den Phasen U, V, W wird durch Umschalten der in Figur 1 gezeigten Schalter 102. 104 erzielt. Die Messung des Operationsverstärker-Offsets erfolgt hier beim Übergang der Halbperiode A in die Halbperiode B innerhalb des Zeitfensters $t_x$.

Gemäß einem Ansatz der vorliegende Erfindung ist eine Kompensation eines Offsetfehlers durch Stromwelligkeit möglich.

Durch die Ausgabe von unterschiedlichen Spannungsvektoren während der Teilperioden B und A kommt es bei einer asymmetrischen Pulsweitenmodulation mit Phasenverschiebung zu einer Welligkeit des Stromes. Im folgenden wird diese Welligkeit auch als Ripple bezeichnet. Dieser Stromrippel hat dabei die gleiche Frequenz wie die Pulsweitenmodulation. Da die beiden für eine Strommessung erforderlichen Ströme zu unterschiedlichen Abtastzeitpunkten bestimmt werden, führt dieser Stromrippel zu einem Offsetfehler in der Strommessung.

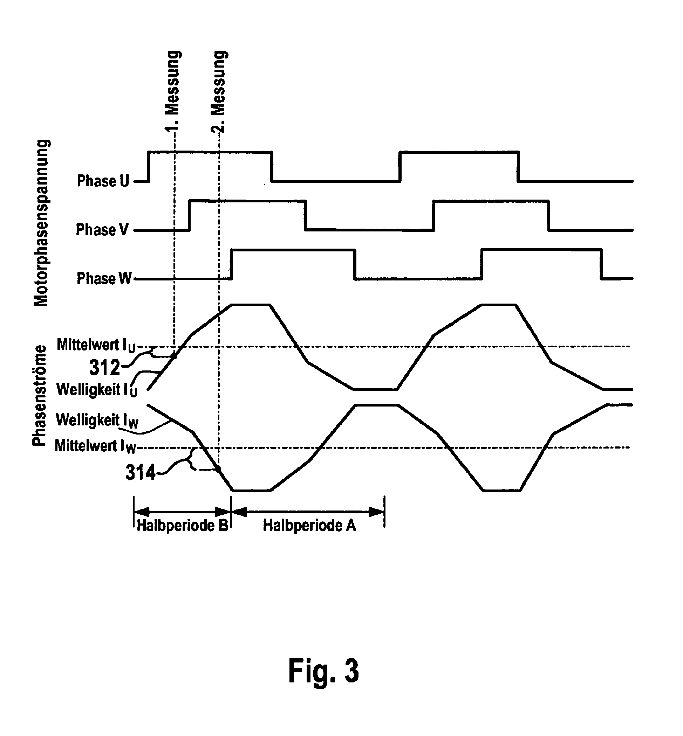

Figur 3 zeigt den Offsetfehler bei asymmetrischer Pulsweitenmodulation mit Phasenverschiebung und insbesondere ist dargestellt, wie der Offsetfehler durch Stromwelligkeit entsteht. Es sind zwei Pulsweitenmodulation-Perioden mit entsprechendem Stromrippel dargestellt.

Im oberen Diagramm der Figur 3 sind die Verläufe der Motorspannung auf den Phasen U, V, W dargestellt. In dem unteren Diagramm sind die Verläufe der Phasenströme $I_u$, lw dargestellt. Für den Phasenstrom $I_u$, lw ist jeweils der Mittelwert und die Welligkeit dargestellt. Sowohl die erste Messung als auch die zweite Messung erfolgt in der Halbperiode B, an die die Halbperiode A anschließt. Mit der ersten Messung wird der Phasenstrom $I_u$ gemessen. Der Offsetfehler 312 bezüglich des Phasenstrom $I_u$ ist zum Zeitpunkt der ersten Messung als Abstand zwischen dem Mittelwert und der Welligkeit des Phasenstrom $I_u$ dargestellt. Der Offsetfehler 314 bezüglich des Phasenstrom lw ist zum Zeitpunkt der ersten Messung als Abstand zwischen dem Mittelwert und der Welligkeit des Phasenstrom 1, dargestellt.

Der Strommessfehler durch die asymmetrische Pulsweitenmodulation mit Phasenverschiebung ist von der Batteriespannung $U_{bat}$, den ohmschen Widerständen $R_{FET}$ und $R_{motor}$, der Motorinduktivitäten $L_{Motor}$ und der Zeit t zwischen Eingangssprung und Messzeitpunkt abhängig.

Dabei werden die ohmschen Widerstände $R_{FET}$ und $R_{Motor}$ sowie die Motorinduktivität $L_{Motor}$ wiederum von der Temperatur beeinflusst. Hinzu kommt bei der Induktivität noch der Einfluss vom magnetischen Fluss in der Maschine bzw. der Sättigung des Eisens.

Im Gegensatz zur Kompensation des Temperaturoffsets kann bei der Kompensation des Rippeloffsets nicht auf bestehende Verfahren bei der 3-Shuntstrommessung und somit mittenzentrierte Pulsweitenmodulation zurückgegriffen werden, bei der die Stromwerte nicht seriell, sondern parallel abgetastet werden und der Messzeitpunkt so gewählt wird, dass die Ströme im Nulldurchgang dieser Welligkeit ermittelt werden und somit kein Offsetfehler entsteht.

Gemäß diesem Ausführungsbeispiel erfolgt eine Kompensation des Offset durch Stromwelligkeit mittels Doppelabtastung.

Eine Möglichkeit zur Kompensation des Stromrippelfehlers bietet die Symmetrie der Welligkeit. Diese lässt sich ausnutzen, indem der Stromwert in der negative Halbwelle erneut abgetastet und eine Mittelwertbildung aus beiden Werten vorgenommen wird. Dazu wird die in Figur 3 gezeigte Messung um eine zweite Messung für beide Ströme $I_u$, lw in der Halbperiode A erweitert.

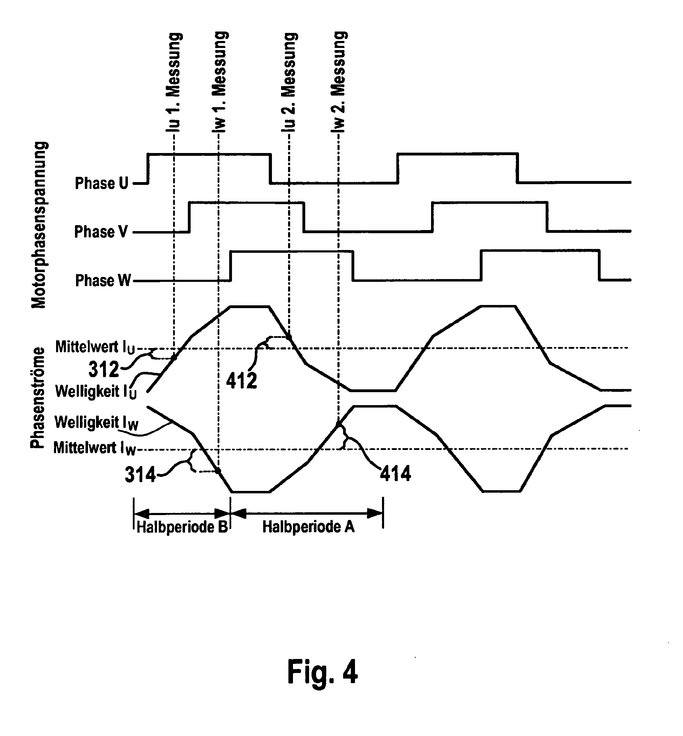

Figur 4 zeigt den Ablauf der Strommessung mit automatischer Rippeloffsetkompensation durch Doppelabtastung gemäß einem Ausführungsbeispiel der vorliegenden Erfindung. Neben den bereits in Figur 3 dargestellten Messungen "lu 1. Messung", "$I_w$ 1. Messung" sind in Figur 4 zwei weitere Messungen "$I_u$ 2. Messung", "lw 2. Messung" gezeigt, die in der Halbperiode A durchgeführt werden. Entsprechende Offsetfehler 412, 414 sind für die Phasenströme $I_u$, $I_w$ jeweils zu den Zeitpunkten der zweiten Messungen dargestellt.

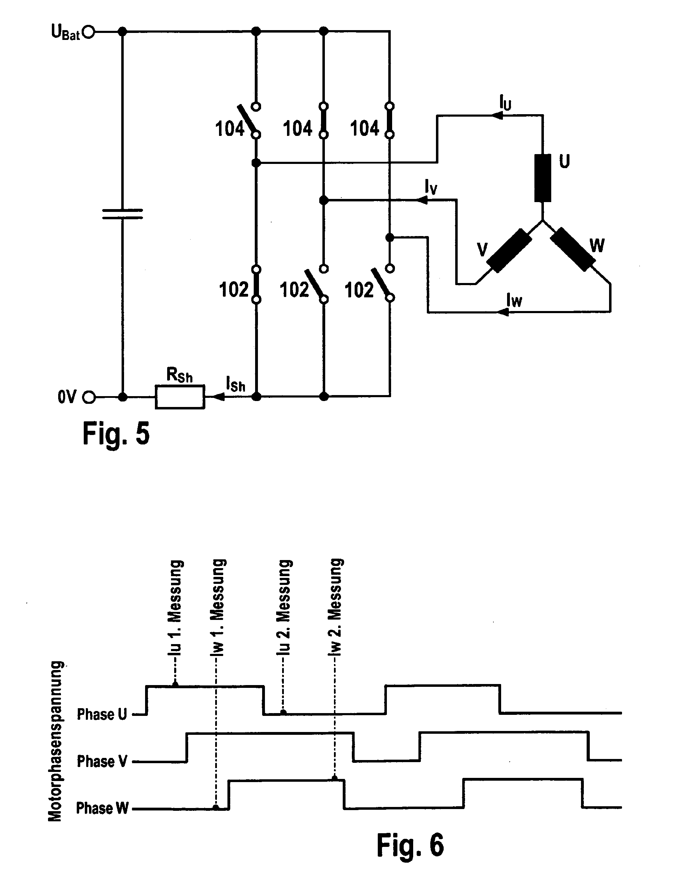

Gemäß diesem Ausführungsbeispiel sind die Zeitpunkte der zweiten Messungen von entscheidender Bedeutung. Sie müssen im exakt gleichen Abstand zum Schalten der entsprechenden FETs 102, 104 der Phasen U, V, W wie bei den ersten Messungen erfolgen. Nur so kann gewährleistet werden, dass der Messfehler durch den Rippeloffset bei beiden Messungen der gleiche ist und so die Symmetrie der Stromwelligkeit ausgenutzt wird. Ein weiterer Vorteil dieses Verfahrens besteht darin, dass der Offsetfehler durch die Temperaturdrift ebenfalls automatisch behoben wird, da dieser in der zweiten Messung mit umgekehrtem Vorzeichen dem Phasenstrom überlagert ist. Dies lässt sich am besten am Beispiel der Strommessung in der Phase U zeigen. Zum Zeitpunkt "lu 1. Messung" sind die FETs so geschaltet, dass der Shuntstrom dem Strom in Phase U entspricht. Ein Offset wirkt sich hier somit mit dem gleichen Vorzeichen wie das Nutzsignal im Messergebnis aus. Bei der zweiten Messung des Phasenstroms lu in der Halbperiode A entspricht der Shuntstrom nun dem Strom, der aus der Phase U heraus fließt und hat somit ein negatives Vorzeichen. Dieses Verhalten wird in Figur 5 verdeutlicht.

Figur 5 zeigt eine Stellung der bereits in Fig. 1 gezeigten B6-Brücke zum Zeitpunkt "lu 2.Messung", wie er in Figur 4 gezeigt ist. Gemäß diesem Ausführungsbeispiel fließt der Offset nun mit umgekehrten Vorzeichen wie das Nutzsignal in das Messergebnis ein und hebt sich somit bei einer Mittelwertbildung auf.

Die Gl.2 stellt diesen Zusammenhang noch einmal für den Strom in der Phase U dar:

$$I_U = (I_{U1,Messung} - I_{U2,Messung})/2 \qquad\qquad (2)$$

wobei für die beiden Messergebnisse $I_{u1,Messung}$ und $I_{u2,Messung}$ gilt:

$$I_{u1.Messung} = I_U + \text{Rippeloffset} + \text{Temperaturoffset} \qquad (3)$$

bzw.

$$I_{u2,Messung} = -I_U + \text{Rippeloffset} + \text{Temperaturoffset} \qquad (4)$$

Bei der Berechnung des zweiten Phasenstromes ist lediglich zu berücksichtigen, dass die erste Messung den Strom mit negativem Vorzeichen und die zweite Messung den Strom mit positivem Vorzeichen liefert. Es ergibt sich folglich:

$$I_w = (I_{w2,Messung} - I_{w1,Messung}) / 2 \qquad (5)$$

wobei für die beiden Messergebnisse $I_{w1,Messung}$ und $I_{W2,Messung}$ gilt:

$$I_{w1,Messung} = -I_W + \text{Rippeloffset} + \text{Temperaturoffset} \qquad (6)$$

bzw.

$$I_{w2,Messung} = I_W + \text{Rippeloffset} + \text{Temperaturoffset} \qquad (7)$$

Das gerade beschriebene erfindungsgemäße Verfahren kann nur bei bestimmten Pulsweitenmodulation-Mustem angewendet werden kann.

Figur 6 zeigt ein Schaltmuster, bei der eine zweite Messung des Phasenstroms W und somit eine Doppelabtastung nicht möglich ist. Gezeigt sind in Figur 6 wiederum die Motorspannungen der Phasen U, V, W und die Messungen "$I_u$ 1. Messung", "$I_w$ 1. Messung", "$I_u$ 2. Messung", "$I_w$ 2. Messung". Die Messung "Iw 2. Messung" kann jedoch nicht verwertet werden, da die Motorphasenspannung der Phase V im Bezug auf den Zustand während der Messung "$I_w$ 1. Messung" nicht invertiert ist.

Auch eine Verschiebung des Messzeitpunktes kann hier die zweite Messung nicht ermöglichen, da in der Halbperiode A nie ein Schaltmuster zu finden ist, das den gesuchten Strom $I_w$, lange genug durch den Shunt fließen lässt, so dass am Eingang des Analog-Digital-Wandlers der Messeinrichtung ein eingeschwungener Wert abzutasten wäre. Da diese Schaltmuster im Normalbetrieb eher die Regel als die Ausnahme darstellen, kann der zuletzt ermittelte Rippeloffset in der Software ermittelt und hinterlegt werden. Dies ist recht einfach möglich, indem der Strom, der mit Hilfe einer Messung bei möglicher Doppelabtastung ermittelt wird, von dem Rohwert aus der ersten Messung dieser Doppelabtastung abgezogen wird. Dieser hinterlegte Wert kann dann zur Offsetkompensation verwendet, wenn eine Doppelabtastung nicht möglich ist.

**Patentansprüche**

1. Verfahren zur Kompensation eines Offsetfehlers bei einer Strommessung in einem mehrphasigen Stromnetz, das die folgenden Schritte aufweist:

    - Erfassen eines zwischen einer ersten Phase (U, V, W) des mehrphasigen Stromnetzes und einem ersten Spannungspotential (OV) fließenden ersten Stromwertes ($I_{Sh}$) zu einem ersten Erfassungszeitpunkt;
    - Erfassen eines zwischen der ersten Phase und dem ersten Spannungspotential fließenden zweiten Stromwertes ($I_{Sh}$) zu einem zweiten Erfassungszeitpunkt, wobei der erste und der zweite Erfassungszeitpunkt so gewählt sind, dass der erste und der zweite Stromwert unterschiedliche Vorzeichen aufweisen; und
- Ermitteln des Offsetfehlers aus dem ersten und dem zweiten Stromwert, wobei das Erfassen des ersten und des zweiten Stromwertes mittels einer Messeinrichtung ($R_{Sh}$) durchgeführt wird, die zwischen dem ersten Spannungspotential (OV) und einer Mehrzahl erster Schalter (102) angeordnet ist, wobei jeweils eine Phase (U, V, W) des mehrphasigen Stromnetzes über jeweils einen der Mehrzahl erster Schalter mit der Messeinrichtung verbunden wird,

wobei zu dem ersten Erfassungszeitpunkt nur ein, der ersten Phase zugeordneter erster Schalter (102) geschlossen und zu dem zweiten Erfassungszeitpunkt nur der, der ersten Phase zugeordnete erste Schalter geöffnet wird, wobei der erste Erfassungszeitpunkt eine erste vorbestimmte Zeitdauer von einem ersten Schaltvorgang des, der ersten Phase zugeordneten ersten Schalters (102) beabstandet ist und der zweite Erfassungszeitpunkt eine zweite vorbestimmte Zeitdauer von einem zweiten Schaltvorgang des der ersten Phase zugeordneten ersten Schalters beabstandet ist, wobei die erste und die zweite vorbestimmte Zeitdauer gleich sind.

2. Verfahren gemäß Anspruch 1, **dadurch gekennzeichnet, dass** ein dem zweiten Stromwert entsprechender Wert von einem Speicher bereitgestellt wird, wenn das Erfassen des zweiten Stromwertes ($I_{Sh}$) zu dem zweiten Erfassungszeitpunk nicht möglich ist.

3. Verfahren gemäß einem der Ansprüche 1 und 2, **dadurch gekennzeichnet, dass** jede Phase (U, V, W) des mehrphasigen Stromnetzes über jeweils einen zweiten Schalter (104) mit einem zweiten Spannungspotential ($U_{Bat}$) verbunden wird und wobei zu dem ersten Erfassungszeitpunkt nur ein zweiter Schalter der ersten Phase geöffnet und zu dem zweiten Erfassungszeitpunkt nur der zweite Schalter der ersten Phase geschlossen wird.

4. Vorrichtung zur Kompensation eines Offsetfehlers bei einer Strommessung in einem mehrphasigen Stromnetz, mit folgenden Merkmalen:

eine Messeinrichtung ($R_{Sh}$), die zwischen dem ersten Spannungspotential (OV) und einer Mehrzahl erster Schalter (102) angeordnet ist, wobei jeweils eine Phase (U, V, W) des mehrphasigen Stromnetzes über jeweils einen der Mehrzahl erster Schalter mit der Messeinrichtung verbunden wird, wobei die Messeinrichtung ($R_{Sh}$) ausgebildet ist, um einen zwischen einer ersten Phase (U, V, W) des mehrphasigen Stromnetzes und einem ersten Spannungspotential (OV) fließenden ersten Stromwert ($I_{Sh}$) zu einem ersten Erfassungszeitpunkt und einen zwischen der ersten Phase und dem ersten Spannungspotential fließenden zweiten Stromwert ($I_{Sh}$) zu einem zweiten Erfassungszeitpunkt zu erfassen, wobei der erste und der zweite Erfassungszeitpunkt so gewählt sind, dass der erste und der zweite Stromwert unterschiedliche Vorzeichen aufweisen, wobei zu dem ersten Erfassungszeitpunkt nur ein, der ersten Phase zugeordneter erster Schalter (102) geschlossen und zu dem zweiten Erfassungszeitpunkt nur der, der ersten Phase zugeordnete erste Schalter geöffnet wird, wobei der erste Erfassungszeitpunkt eine erste vorbestimmte Zeitdauer von einem ersten Schaftvorgang des, der ersten Phase zugeordneten ersten Schalters (102) beabstandet ist und der zweite Erfassungszeitpunkt eine zweite vorbestimmte Zeitdauer von einem zweiten Schaltvorgang des der ersten Phase zugeordneten ersten Schalters beabstandet ist, wobei die erste und die zweite Zeitdauer gleich sind; und eine Einrichtung zum Ermitteln des Offsetfehlers aus dem ersten und dem zweiten Stromwert.

## Claims

1. Method for compensating for an offset error during a current measurement in a multiphase power supply system, which method has the following steps:

- recording a first current value ($I_{Sh}$) flowing between a first phase (U, V, W) of the multiphase power supply system and a first voltage potential (0V) at a first recording time;
- recording a second current value ($I_{Sh}$) flowing between the first phase and the first voltage potential at a second recording time, the first and second recording times being selected in such a manner that the first and second current values have different signs; and
- determining the offset error from the first and second current values,

the first and second current values being recorded using a measuring device ($R_{Sh}$) which is arranged between the first voltage potential (0V) and a plurality of first switches (102), a respective phase (U, V, W) of the multiphase power supply system being connected to the measuring device via a respective one of the plurality of first switches, only one first switch (102) associated with the first phase being closed at the first recording time and only the first switch associated with the first phase being opened at the second recording time,

the first recording time being separated from a first switching operation of the first switch (102) associated with the first phase by a first predetermined period of time and the second recording time being separated from a second switching operation of the first switch associated with the first phase by a second predetermined period of time, the first and second predetermined periods of time being identical.

2. Method according to Claim 1, **characterized in that** a value corresponding to the second current value is provided by a memory when it is not possible to record the second current value ($I_{Sh}$) at the second recording time.

3. Method according to either of Claims 1 and 2, **characterized in that** each phase (U, V, W) of the multiphase power supply system is connected to a second voltage potential ($U_{Bat}$) via a respective second switch (104), only one second switch of the first phase being opened at the first recording time and only the second switch of the first phase being closed at the second recording time.

4. Apparatus for compensating for an offset error during a current measurement in a multiphase power supply system, having the following features:

a measuring device ($R_{Sh}$) which is arranged between the first voltage potential (0V) and a plurality of first switches (102), a respective phase (U, V, W) of the multiphase power supply system being connected to the measuring device via a respective one of the plurality of first switches, the measuring device ($R_{Sh}$) being designed to record a first current value ($I_{Sh}$) flowing between a first phase (U, V, W) of the multiphase power supply system and a first voltage potential (0V) at a first recording time and to record a second current value ($I_{Sh}$) flowing between the first phase and the first voltage potential at a second recording time, the first and second recording times being selected in such a manner that the first and second current values have different signs, only one first switch (102) associated with the first phase being closed at the first recording time and only the first switch associated with the first phase being opened at the second recording time,

the first recording time being separated from a first switching operation of the first switch (102) associated with the first phase by a first predetermined period of time and the second recording time being separated from a second switching operation of the first switch associated with the first phase by a second predetermined period of time, the first and second periods of time being identical; and

a device for determining the offset error from the first and second current values.

**Revendications**

1. Procédé de compensation d'une erreur de décalage lors de la mesure d'un courant dans un réseau électrique à plusieurs phases, lequel comprend les étapes suivantes :

- détection, à un premier instant de détection, d'une première valeur du courant ($I_{Sh}$) qui circule entre une première phase (U, V, W) du réseau électrique à plusieurs phases et un premier potentiel de tension (0V) ;
- détection, à un deuxième instant de détection, d'une deuxième valeur du courant ($I_{Sh}$) qui circule entre la première phase et le premier potentiel de tension, le premier et le deuxième instant de détection étant choisis de telle sorte que la première et la deuxième valeur du courant présentent des signes différents ; et
- détermination de l'erreur de décalage à partir de la première et de la deuxième valeur du courant, la détection de la première et de la deuxième valeur du courant étant effectuée au moyen d'un dispositif de mesure ($R_{Sh}$) qui est disposé entre le premier potentiel de tension (0V) et une pluralité de premiers commutateurs (102), une phase (U, V, W) du réseau électrique à plusieurs phases étant à chaque fois reliée au dispositif de mesure respectivement par le biais de l'un de la pluralité de premiers commutateurs, un seul des premiers commutateurs (102), celui affecté à la première phase, étant fermé au premier instant de détection et seul celui des premiers commutateurs qui est affecté à la première phase étant ouvert au deuxième instant de détection,

le premier instant de détection étant espacé d'une première durée prédéfinie d'une première opération de commutation de celui des premiers commutateurs (102) qui est affecté à la première phase, et le deuxième instant de détection étant espacé d'une deuxième durée prédéfinie d'une deuxième opération de commutation de celui des premiers commutateurs qui est affecté à la première phase, la première et la deuxième durée prédéfinie étant identiques.

2. Procédé selon la revendication 1, **caractérisé en ce qu'**une valeur correspondant à la deuxième valeur du courant est fournie par une mémoire lorsque la détection de la deuxième valeur du courant ($I_{Sh}$) n'est pas possible au deuxième instant.

3. Procédé selon l'une des revendications 1 et 2, **caractérisé en ce que** chaque phase (U, V, W) du réseau électrique à plusieurs phases est reliée à chaque fois par le biais d'un deuxième commutateur (104) à un deuxième potentiel de tension ($U_{Bat}$), et un seul deuxième commutateur de la première phase étant ouvert au premier instant de détection et seul le deuxième commutateur de la première phase étant fermé au deuxième instant de détection.

4. Dispositif de compensation d'une erreur de décalage lors de la mesure d'un courant dans un réseau électrique à plusieurs phases, lequel présente les caractéristiques suivantes :

   un dispositif de mesure ($R_{Sh}$) qui est disposé entre le premier potentiel de tension (0V) et une pluralité de premiers commutateurs (102), une phase (U, V, W) du réseau électrique à plusieurs phases étant à chaque fois reliée avec le dispositif de mesure respectivement par le biais de l'un de la pluralité de premiers commutateurs,
   le dispositif de mesure ($R_{Sh}$) étant configuré pour détecter, à un premier instant de détection, une première valeur du courant ($I_{Sh}$) qui circule entre une première phase (U, V, W) du réseau électrique à plusieurs phases et un premier potentiel de tension (0V) et, à un deuxième instant de détection, une deuxième valeur du courant ($I_{Sh}$) qui circule entre la première phase et le premier potentiel de tension, le premier et le deuxième instant de détection étant choisis de telle sorte que la première et la deuxième valeur du courant présentent des signes différents, un seul des premiers commutateurs (102), celui affecté à la première phase, étant fermé au premier instant de détection et seul celui des premiers commutateurs qui est affecté à la première phase étant ouvert au deuxième instant de détection,
   le premier instant de détection étant espacé d'une première durée prédéfinie d'une première opération de commutation de celui des premiers commutateurs (102) qui est affecté à la première phase, et le deuxième instant de détection étant espacé d'une deuxième durée prédéfinie d'une deuxième opération de commutation de celui des premiers commutateurs qui est affecté à la première phase, la première et la deuxième durée étant identiques ; et
   un dispositif pour déterminer l'erreur de décalage à partir de la première et de la deuxième valeur du courant.

Fig. 1

Fig. 2

**Fig. 3**

Fig. 4

13

Fig. 5

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5309349 A